# EUROPÄISCHE PATENTANMELDUNG

(11) **EP 0 864 874 A2**
(43) Veröffentlichungstag der Anmeldung: **16.09.1998**
(21) Anmeldenummer: 98104319.3
(22) Anmeldetag: 10.03.1998
(51) Int. Cl.: G01R 31/28, G01R 31/309, G01N 21/88

(54) **Verfahren und Vorrichtung zum Prüfen von Leiterplatten**

(30) Priorität: 11.03.1997 DE 19709939
(71) Anmelder: Atg test systems GmbH, 97877 Wertheim (DE)
(72) Erfinder: Huth, Ralf, 72800 Eningen (DE); Gillig, Thomas, 97264 Helmstadt (DE); Rothaug, Uwe, 97828 Marktheldenfeld (DE)
(74) Vertreter: Ganahl, Bernhard

(57) **Zusammenfassung**

Die Erfindung betrifft ein Verfahren und eine Vorrichtung zum Prüfen von Leiterplatten, wobei zur Ermittlung optischer Fehler eine zu prüfende Leiterplatte optisch abgetastet wird, und Netze der zu prüfenden Leiterplatte, die in der Nähe der optischen Fehler angeordnet sind, elektrisch nachgemessen werden.

Durch die Kombination aus optischen und elektrischen Meßverfahren wird die Prüfgeschwindigkeit und die Prüfgenauigkeit im Vergleich zu herkömmlichen Prüfverfahren wesentlich verbessert.

## Beschreibung

Die Erfindung betrifft ein Verfahren und eine Vorrichtung zum Prüfen von Leiterplatten.

Leiterplatten weisen eine Vielzahl von Netzen auf, wobei deren Dichte auf den Leiterplatten sich mit der kontinuierlich fortschreitenden Miniaturisierung der elektronischen Bauelemente zunehmend erhöht.

Das Testen von Leiterplatten mittels optischer Testverfahren und Testvorrichtungen ist hinlänglich bekannt (z.B. WO 92/09880, WO 93/15474). Derartige Vorrichtungen weisen eine optische Abtasteinrichtung auf, wie z.B. eine Kamera, mit welcher eine zu testende Leiterplatte abgetastet wird. Die so ermittelte Abbildung der Leiterplatte wird digitalisiert, d.h., daß eine Bilddaten-Datei erstellt wird, deren Dateninhalt der Abbildung entspricht. Die Bilddaten-Datei besteht in der Regel aus einer Liste von Koordinaten, wobei jeder Koordinate ein Grauwert zugeordnet ist. Diese Bilddaten-Datei wird automatisch mittels eines Erkennungsprogrammes gelesen, das die einzelnen Leiterbahnen, Kontaktstellen und dgl. erkennt und in einer Merkmalsdatei abspeichert, in der alle optischen Merkmale der zu testenden Leiterplatte enthalten sind.

Diese Merkmalsdatei wird mit einer Referenz-Merkmalsdatei verglichen. Werden bei diesem Vergleich keine Abweichungen festgestellt, so ist die getestete Leiterplatte fehlerfrei. Sollten aber Abweichungen festgestellt werden, so ist dies ein Hinweis, daß die zu testende Leiterplatte einen Fehler, wie z.B. einen Kurzschluß oder eine Unterbrechung in einem Netz, aufweist.

Diese Fehler müssen dann vom Bediener der Prüfvorrichtung manuell untersucht werden. Der Bediener, der in der Regel viel Erfahrung im Testen von Leiterplatten besitzen sollte, betrachtet die Leiterplatte mit dem bloßen Auge und beurteilt, ob die optischen Abweichungen tatsachlich Fehler darstellen, oder ob sie auf irgendwelchen anderen Ursachen beruhen, wie z.B. Flecken oder dgl.

Diese optischen Prüfvorrichtungen erlauben einen sehr schnellen Test einer gesamten Leiterplatte und sind sehr flexibel, da mit derartigen Prüfvorrichtungen unterschiedliche Leiterplatten getestet werden können, ohne daß hierfür mechanische Änderungen an der Vorrichtung notwendig sind.

Nachteilig ist jedoch, daß bei fehlerhaften Leiterplatten fast immer eine manuelle Untersuchung erfolgen muß. Dies bedeutet eine wesentliche Verzögerung des an sich sehr schnellen Testverfahrens. Zudem sind die optischen Testverfahren sehr personalintensiv, und die manuellen Untersuchungen können nur Bediener mit viel Erfahrung beim Testen von Leiterplatten durchführen. Durch eine Erhöhung der Auflösung kann die korrekte automatische Ermittlung von Fehlern (="Treffer") verbessert werden, wodurch jedoch die Testgeschwindigkeit verlangsamt wird. Je dichter die Leiterplatten mit Netzen bestückt sind, desto schwieriger ist es, bei einer zufriedenstellenden Trefferquote die Testzeiten gering bzw. die Testgeschwindigkeit hoch zu halten.

Bei den immer feiner werdenden Leiterbahnen muß die optische Auflösung erhöht werden, wobei es zur Zeit möglich ist Punkte mit einer Größe von 0,1 µm zu efassen. Bei feinsten Leiterbahnen und feinsten Kontaktpunkten, die oftmals nur aus einem Restring bestehen, bestehen trotz der hohen Auflösung beträchtliche Probleme bei der optische Erfassung.

Bekannte elektrische Vorrichtungen zum Prüfen von Leiterplatten können grundsätzlich in zwei Gruppen unterteilt werden. Zur ersten Gruppe gehören die Vorrichtungen mit Adapter, bei welchen alle Prüfpunkte einer Leiterplatte gleichzeitig mittels des Adapters kontaktiert werden. Die zweite Gruppe umfaßt die sogenannten Fingertester. Das sind Vorrichtungen, die mit zwei oder mehr Prüffingern die einzelnen Prüfpunkte sequentiell abtasten.

Fingertester sind bspw. aus der DE 41 09 684 A1 bzw. der EP 0 468 153 A1 bekannt. Fingertester weisen eine hohe Flexibilität auf, da wie bei den optischen Prüfvorrichtungen beim Wechsel des zu testenden Leiterplattentyps keine mechanischen Änderungen vorgenommen werden müssen. Fingertester sind jedoch gegenüber mit Adapter arbeitenden Vorrichtungen grundsätzlich langsamer, da die Prüfpunkte sequentiell abgetastet werden müssen. In den letzten Jahren wurde durch geschickte Verfahren die Anzahl der pro Leiterplatte auszuführenden Messungen deutlich verringert, und es ist mittlerweile auch möglich, mehrere Messungen gleichzeitig durchzuführen, so daß die gesamte Meßzeit verringert werden konnte.

Unabhängig von der Art der Vorrichtung werden die einzelnen Netze auf Unterbrechungen in den Netzen ("Unterbrechungstest") und auf elektrische Verbindungen zu anderen Netzen ("Kurzschlußtest") getestet. Der Kurzschlußtest kann sowohl die Detektion von niederohmigen als auch von hochohmigen Verbindungen umfassen.

Sowohl für den Unterbrechungstest als auch für den Kurzschlußtest sind unterschiedliche Meßverfahren bekannt. Hierbei wird jedes Netz auf einen Kurzschluß bzw. jeder Zweig eines Netzes auf eine Unterbrechung untersucht, so daß bei modernen Leiterplatten mit einer Vielzahl von Netzen eine entsprechend hohe Anzahl einzelner Meßvorgänge durchgeführt werden muß.

Man hat versucht, die einzelnen Meßvorgänge zu optimieren und deren Anzahl zu minimieren, wobei eine Vielzahl unterschiedlicher Verfahren vorgeschlagen und umgesetzt worden sind.

Der Erfindung liegt die Aufgabe zugrunde, eine einfache Vorrichtung und ein einfaches Verfahren zum Prüfen von Leiterplatten zu schaffen, mit dem Leiterplatten sehr schnell bei hoher Zuverlässigkeit getestet werden können, und das einfach automatisiert werden kann.

Die Aufgabe wird durch ein Verfahren nach Anspruch 1 und durch eine Vorrichtung nach Anspruch 13 gelöst. Vorteilhafte Ausgestaltungen der Erfindung sind in den Unteransprüchen angegeben.

Erfindungsgemäß werden die Leiterplatten zuerst optisch getestet, indem eine zu testende Leiterplatte optisch abgetastet wird, die hierdurch erhaltene Ist-Abbildung mit einer Referenz-Abbildung verglichen und ermittelt wird, ob Abweichungen zwischen der Ist-Abbildung und der Referenz-Abbildung bestehen. Falls derartige Abweichungen bestehen, werden sie als optische Fehler bewertet. Ihre Lage auf der Leiterplatte wird ermittelt, und die Leiterplatte einem elektrischen Test unterzogen, bei dem Netze der zu testenden Leiterplatte im Bereich der ermittelten optischen Fehler elektrisch gemessen werden.

Das erfindungsgemäße Verfahren ist eine simple Kombination an sich bekannter optischer und elektrischer Meßverfahren. Durch das erfindungsgemäße Verfahren werden bahnbrechende Vorteile beim automatisierten Testen von Leiterplatten hinsichtlich der Geschwindigkeit und Zuverlässigkeit erzielt, da mit dem optischen Prüfverfahren sehr schnell eine gesamte Leiterplatte abgetastet werden kann, und danach nur noch wenige Prüfpunkte im Falle von Abweichungen auf der Leiterplatte elektrisch nachgemessen werden müssen. Aufgrund der geringen Anzahl von elektrisch zu messenden Prüfpunkten läßt sich das elektrische Meßverfahren sehr schnell mit an sich bekannten Fingertestern durchfuhren. Gegenüber herkömmlichen optischen Testverfahren kann die optische Testeinrichtung sehr scharf eingestellt werden, d.h., daß mit einer sehr hohen optischen Auflösung gemessen wird und geringste Abweichungen zwischen der Ist-Abbildung und der Referenz-Abbildung als optische Fehler bewertet werden können, die dann einzeln elektrisch nachgemessen werden. Durch eine derart scharfe optische Einstellung würde ein Bediener, der die Leiterplatten manuell überprüfen müßte, völlig überfordert werden, da zum einen an den meisten Leiterplatten derartige optische Fehler wahrgenommen werden und zum anderen die Anzahl der wahrgenommenen optischen Fehler pro Leiterplatte wesentlich ansteigt, die alle überprüft werden müßten. Für die den optischen Prüfeinrichtungen nachgeschalteten elektrischen Prüfeinrichtungen, die üblicherweise für das Messen von einigen 10- bis 100-Tausend Messungen pro Leiterplatte ausgelegt sind, stellt das Nachmessen von einigen zehn bis hundert optischen Fehlern eine in einigen Sekunden lösbare Aufgabe dar. So können bekannte Fingertester mit vier Prüffingern etwa 10 Messungen pro Sekunde durchführen. Eine manuelle Überprufung eines ahrgenommenen optischen Fehlers dauert hingegen etwa 30 Sekunden.

Durch das erfindungsgemäße Verfahren werden somit sensationelle Fortschritte bzgl. der Meßgenauigkeit und der Meßgeschwindigkeit beim automatisierten Prüfen von Leiterplatten erzielt, da sich das optische und elektrische Meßverfahren in idealer Weise ergänzen.

Die Erfindung wird nachfolgend anhand der Zeichnungen näher erläutert. Es zeigen:
- Fig. 1: das erfindungsgemäße Verfahren in einem Flußdiagramm,
- Fig. 2: eine automatisierte Vorrichtung zum Prüfen von Leiterplatten nach der Erfindung, und
- Fig. 3: eine integrierte erfindungsgemäße Vorrichtung zum Prüfen von Leiterplatten.

Nach dem erfindungsgemäßen Verfahren wird in einem ersten Arbeitsschritt S1 eine zu testende Leiterplatte optisch abgetastet. Das optische Abtasten erfolgt vorzugsweise mit einer digitalen Kamera, die als lichtempfindliches Element bspw. ein CCD-Element (Charged Coupled Device) aufweist, mit welchem die Leiterplatte zeilenweise oder auch flächig an mehreren Segmenten abgetastet wird. Um eine ausreichende Auflösung zu erzielen, ist es in der Regel notwendig, daß die Kamera und die Leiterplatte zueinander bewegt werden, wobei sowohl ein Bewegen der Kamera als auch ein Bewegen der Leiterplatte möglich ist. Vorzugsweise wird während des optischen Abtastvorganges entweder die Kamera oder die Leiterplatte ortsfest gehalten.

Mit dem optischen Abtastvorgang wird eine gemessene Abbildung der Leiterplatte erhalten, die beim Abtasten mittels einer digitalen Kamera durch eine Bilddaten-Datei dargestellt wird. Der Dateninhalt der Bilddaten-Datei besteht im Falle eines Schwarz/-Weiß-Bildes aus einer Liste von Grauwerten, wobei jeder Grauwert einem Bildpunkt (Pixel) bzw. dessen Koordinaten zugeordnet ist. Bei Farbbildern enthält die Bilddaten-Datei anstatt Grauwerten Farbwerte.

Die Bilddaten-Datei wird dann digitalisiert, d.h., daß Grauwerte unter einem bestimmten Schwellwert auf "0" (=weiß) gesetzt werden und Grauwerte über einem bestimmten Schwellwert auf "1" (=schwarz) gesetzt werden.

Die digitalisierte Bilddaten-Datei wird dann mittels eines Erkennungsprogrammes gelesen, das die einzelnen Leiterbahnen, Kontaktstellen und dgl. erkennt und mit ihren Koordinaten in einer Elementen-Datei abspeichert.

Die Elementen-Datei wird mit einer Referenz-Elementen-Datei im Arbeitsschritt S2 verglichen, wobei die Elementen-Datei eine Ist-Abbildung der abgetasteten Leiterplatte und die Referenz-Elementen-Datei eine Referenz-Abbildung darstellt. Abweichungen der einzelnen Elemente in den beiden Dateien werden als optische Fehler registriert und mit ihren Koordinaten in einer Fehler-Datei abgespeichert (Schritt S3). Werden keine Abweichungen festgestellt, so wird die zu testende Leiterplatte als fehlerfrei bewertet und der Prüfvorgang beendet (Schritt E1).

Die zu testende Leiterplatte wird nach dem optischen Test elektrisch, bspw. mittels eines Fingertesters, geprüft. Aus der Fehlerdatei werden die Koordinaten der optischen Fehler gelesen und die zu den optischen Fehlern benachbart angeordneten Netze der zu testenden Leiterplatte werden ermittelt. Diese zu den optischen Fehlern benachbart angeordneten Netze werden elektrisch auf Unterbrechung und/oder Kurzschluß zu einem weiteren Netz getestet (Schritt S4).

Werden beim elektrischen Test keine Fehler, d.h. Unterbrechungen oder Kurzschlüsse, festgestellt, so wird die Leiterplatte als fehlerfrei bewertet (Schritt E2). Werden ein oder mehrere Fehler festgestellt, so wird die Leiterplatte als fehlerhaft bewertet (Schritt E3). Die Art und die Koordinaten des bzw. der Fehler können ermittelt und für eine spätere Reparatur der Leiterplatte abgespeichert bzw. ausgegeben werden.

Wie die gemessene Abbildung der Leiterplatte zur Ist-Abbildung weiterverarbeitet wird, ist für das Prinzip der vorliegenden Erfindung nicht wesentlich. Theoretisch wäre es sogar möglich, daß die gemessene Abbildung unmittelbar mit einer entsprechenden Referenz-Abbildung verglichen wird. Für das erfindungsgemäße Verfahren ist es wesentlich, daß in einem optischen Prüfvorgang optische Fehler wahrgenommen werden, die potentielle elektrische Fehler darstellen. Diese optischen Fehler werden dann elektrisch nachgemessen, so daß eindeutig festgestellt werden kann, ob ein oder kein elektrischer Fehler vorliegt. Das Wahrnehmen der optischen Fehler geschieht üblicherweise durch einen Vergleich der durch optisches Abtasten der zu testenden Leiterplatte ermittelten Daten, der Ist-Abbildung, mit Referenz-Daten, der Referenz-Abbildung. Dieser optische Vergleich kann auch bereichsweise erfolgen, das bedeutet, daß bspw. einzelne Netze separat erfaßt und verglichen werden.

Das erfindungsgemäße Verfahren läßt sich mit an sich bekannten Prüfvorrichtungen zum optischen und elektrischen Prüfen durchfuhren, wobei eine Datenverbindung von der optischen zur elektrischen Prüfvorrichtung bestehen sollte, damit die Fehlerdatei, d.h. die Liste der optischen Fehler, an die elektrische Prüfvorrichtung weitergeleitet werden kann und nur die benachbart zu den optischen Fehlern angeordneten Netze elektrisch geprüft werden müssen.

Die Leiterplatten werden hierbei manuell von der optischen Prüfeinrichtung entfernt und in die elektrische Prüfeinrichtung eingelegt. Vorzugsweise ist an den zu testenden Leiterplatten ein maschinenlesbarer Code, wie z.B. ein Bar-Code, angebracht, damit die Prüfeinrichtungen automatisch die korrekte Zuordnung von Leiterplatte und Fehlerdatei durchführen können.

Eine einfache Form der Automatisierung sieht einen Roboterarm vor, der die Leiterplatten der optischen Prüfeinrichtung entnimmt und in die elektrische Prüfeinrichtung einlegt.

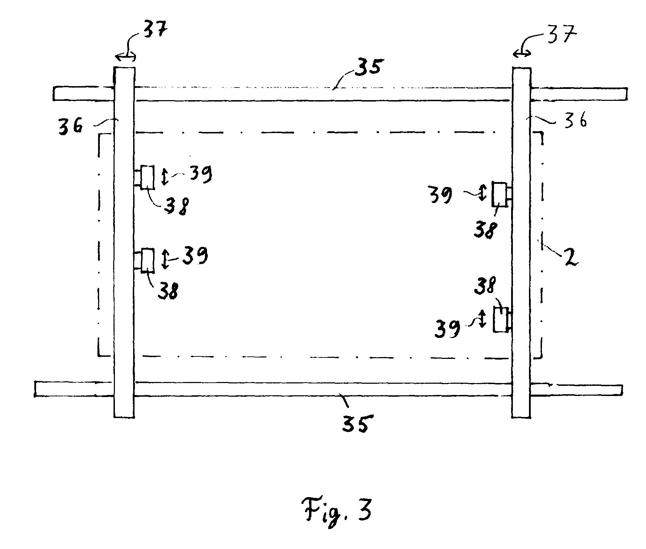

In Fig. 2 ist schematisch vereinfacht eine erfindungsgemäße Vorrichtung zum Prüfen von Leiterplatten dargestellt. Diese Vorrichtung weist ein langgestrecktes Förderband 1 auf, das die zu testenden Leiterplatten 2 in Förderrichtung 3 befördert. Das Förderband 1 ist vorzugsweise aus zwei parallel zueinander angeordneten Förderbändern ausgebildet, die zwischen sich einen Spalt begrenzen, über den sich die auf dem Förderband 1 liegenden Leiterplatten 2 erstrecken.

Am in Förderrichtung 3 vorderen Ende des Förderbandes 1 ist ein Schacht 5 angeordnet, der ähnlich einem Paternosterlift einzelne Stapel von Leiterplatten 2 zuführt. Der Schacht 5 entspricht dem in der parallelen Patentanmeldung P 196 31 368.6 beschriebenen Zuführschacht.

Oberhalb des Schachtes 5 ist eine Vereinzelungseinrichtung 4 mit einem vertikal verstellbaren Greifarm 6 angeordnet, der an einer Schiene 7 horizontal verschiebbar aufgehängt ist, so daß er von einer Position über dem Schacht 5 in eine Position über dem Förderband 1 verfahren werden kann. Am unteren Ende des Greifarmes 5 sind Saugnäpfe 8 an einer horizontalen Platte 9 angeordnet, mit welchen jeweils eine Leiterplatte 2 aus dem Schacht 5 entnommen und auf dem Förderband 1 abgelegt werden kann.

Der Vereinzelungseinrichtung 4 ist in Förderrichtung 3 eine optische Prüfeinrichtung 10 nachgeordnet. Die optische Prüfeinrichtung weist als Abtasteinrichtung eine CCD-Kamera 11 auf, mit welcher die vom Förderband 1 unter der optischen Prüfeinrichtung fortbewegten Leiterplatten 2 abgetastet werden, und eine gemessene Abbildung erhalten wird. Die gemessene Abbildung wird bspw. gemäß dem oben beschriebenen Verfahren zu einer Ist-Abbildung weiterverarbeitet, wobei dann die Ist-Abbildung mit einer Referenz-Abbildung verglichen wird, und die Abweichungen als optische Fehler bewertet und zusammen mit ihren Koordinaten in einer Fehlerdatei abgespeichert werden.

Der optischen Prüfeinrichtung 10 ist eine elektrische Prüfeinrichtung 15 nachgeordnet. Die elektrische Prüfeinrichtung 15 ist ein Fingertester, der oberhalb des Förderbandes 1 angeordnet ist und zwei in Förderrichtung 3 ausgerichtete Führungsschienen 16 aufweist, auf welchen quer und in Förderrichtung 3 verschiebbar zwei Traversen 17 gelagert sind. An den Traversen 17 ist jeweils zumindest ein Prüfkopf 18 quer zur Förderrichtung 3 verschiebbar angeordnet. Vorzugsweise weisen die Traversen zumindest zwei Prüfköpfe 18 auf. An jedem Prüfkopf 18 steht nach unten ein Prüffinger 19 vor, mit welchem die Prüfpunkte der Leiterplatte 2 zu Prüfzweken kontaktiert werden können.

Erfindungsgemäß wird die Fehlerdatei von der optischen Prüfeinrichtung 10 an die elektrische Prüfeinrichtung 15 weitergeleitet, so daß die elektrische Prüfeinrichtung 15 nach Maßgabe der Fehlerdatei ausgewählte Netze, nämlich diejenigen in der Nähe der optischen Fehler, auf der Leiterplatte elektrisch nachmißt. Die elektrische Messung umfaßt üblicherweise eine Messung auf Unterbrechung des Netzes, die durch eine Leitwertmessung an dem zu prüfenden Netz ausgeführt wird, und eine Messung auf Kurzschluß zwischen zwei Netzen, die durch eine Widerstandsmessung zwischen den beiden zu prüfenden Netzen ausgeführt wird. Für eine elektrische Kurzschlußmessung werden auch Magnetfeldsonden, wie z.B. Squidsensoren, verwendet, die einen durch die zu prüfenden Leitungen geleiteten Strom berührungslos erfassen und dementsprechend einen Kurzschluß feststellen können. Ein solches elektrisches Meßverfahren, das auf der Messung eines magnetischen Feldes beruht liegt selbstverständlich auch im Rahmen der Erfindung. Da im Vergleich zu bekannten elektrischen Prüfverfahren relativ wenige Messungen ausgeführt werden müssen, muß das Meßverfahren nicht mit aufwendigen Analysen und dgl. speziell optimiert werden, da bei einer solch geringen Anzahl von Messungen nur ein sehr geringes Optimierungspotential besteht. Vielmehr kann das erfindungsgemäße Verfahren und die erfindungsgemäße Vorrichtung als ein elektrisches Meßverfahren bzw. elektrische Meßvorrichtung betrachtet werden, die mittels eines optischen Verfahrens bzw. einer optischen Vorrichtung optimiert werden.

Der elektrischen Prüfeinrichtung 15 sind in Förderrichtung 3 zwei Magazine 22, 24 nachgeordnet. Beide Magazine sind über dem Förderband 1 angeordnet, wobei unterhalb der Magazine 22, 24 jeweils ein in einem Zylinder 25, 26 vertikal verfahrbarer Stempel 27, 28 angeordnet ist. Mit den Stempeln 25, 26 kann jeweils eine sich oberhalb des jeweiligen Stempels 25, 26 auf dem Förderband 1 befindliche Leiterplatte 2 vom Förderband 1 abgehoben und in eines der Magazine 22, 24 von unten gedrückt werden. Die Magazine 22, 24 weisen an ihrem unteren Randbereich jeweils elastisch nachgebende Widerlager 29 auf, die die Leiterplatten 2 in den Magazinen 22, 24 halten. In das Magazin 22 werden nur fehlerlose Leiterplatten 2 und in das Magazin 24 nur fehlerhafte Leiterplatten 2 eingeführt. Das Magazin 22 wird auch als Gut-Magazin 22 und das Magazin 24 als Schlecht-Magazin bezeichnet.

Zwischen der optischen Prüfeinrichtung 10 und der elektrischen Prüfeinrichtung 15 kann ein weiteres (Gut-) Magazin 30 mit entsprechendem in einem Zylinder 31 vertikal verfahrbaren Stempel 32 angeordnet sein, um darin alle Leiterplatten 2 ohne optischen Fehler aufzunehmen.

Diese Vorrichtung zum Prüfen von Leiterplatten 2 weist eine zentrale Steuereinrichtung (nicht dargestellt) auf, die alle Vorgänge vom Zufuhren der Leiterplatten 2, dem Befördern auf dem Förderband 1, dem optischen und elektrischen Abtasten und dem Zuführen der getesteten Leiterplatten in die Magazine 22, 24, 30 steuert.

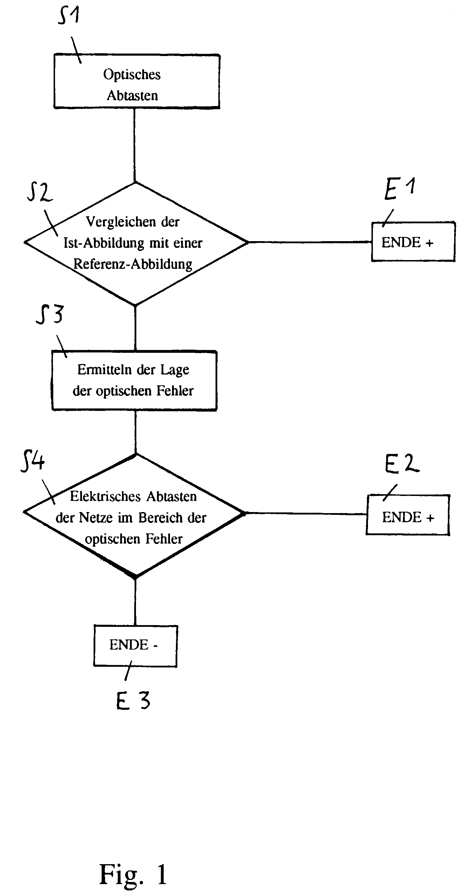

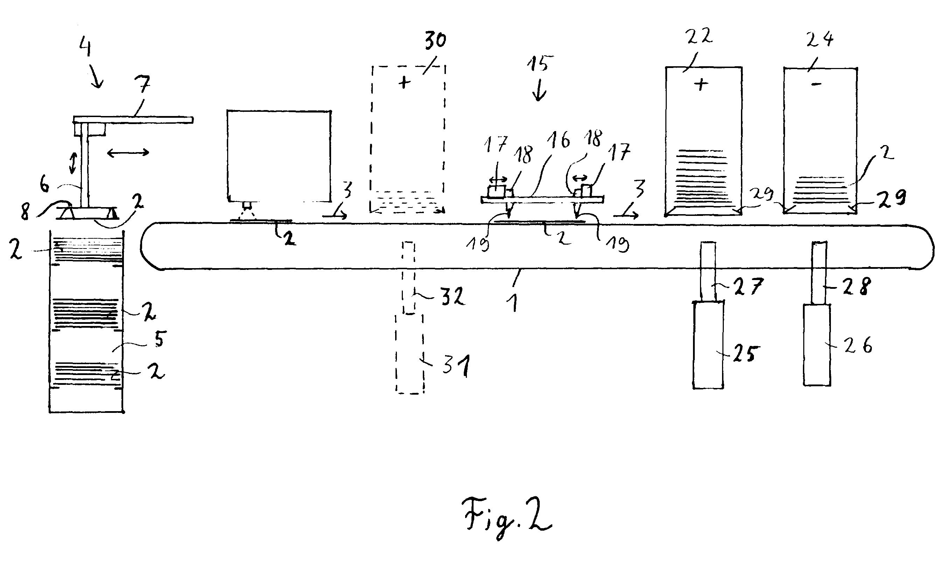

Die einzelnen in Fig. 1 dargestellten Verfahrensschritte werden bei dieser Vorrichtung zum Prüfen elektrischer Leiterplatten in folgenden Einrichtungen ausgeführt:
Das optische Abtasten (S1) erfolgt durch die optische Prüfeinrichtung 10.
Das Vergleichen der Ist-Abbildung mit einer Referenz-Abbildung (S2) kann in der optischen Prüfeinrichtung oder in der zentralen Steuereinrichtung erfolgen.
Bei einer Leiterplatte ohne optischen Fehler wird das Prüfverfahren durch einfuhren der Leiterplatte in das Magazin 30 beendet.
Die Lage der optischen Fehler (S3) kann in der optischen Prüfeinrichtung oder in der zentralen Steuereinrichtung erfolgen.
Das elektrische Abtasten der Leiterplatten (S4) wird durch die elektrische Prüfeinrichtung 15 ausgeführt.
Je nach dem, ob die Leiterplatten einen oder keinen Fehler aufweisen, werden sie dem Gut-Magazin 22 oder dem Schlecht-Magazin 24 zugeführt (E2, E3).

In Fig. 3 ist schematisch grob vereinfacht eine weiteres Ausführungsbeispiel einer erfindungsgemäßen Vorrichtung zum Prüfen von Leiterplatten dargestellt.

Die Vorrichtung weist zwei zueinander parallel angeordnete Schienen 35 auf, zwischen welchen ein Aufnahmebereich für eine zu prüfende Leiterplatte 2 ausgebildet ist. Auf den Schienen lagern zumindest zwei Traversen 36, die sich quer über den Aufnahmebereich für die zu prüfende Leiterplatte 2 erstrecken. Die Traversen 36 sind auf den Schienen 35 in Richtung der Doppelpfeile 37 verfahrbar. Auf den Traversen 36 ist jeweils zumindest ein Prüfkopf 38 verfahrbar angeordnet. Vorzugsweise weist eine jede Traverse zwei Prüfköpfe 38 auf. Die Prüfköpfe 38 sind in Richtung der Doppelpfeile 39 auf den Traversen 36 verfahrbar.

Dieser grundsätzliche Aufbau einer Prüfvorrichtung erlaubt unterschiedliche Ausführungsformen der Erfindung. Nachfolgend werden drei Ausführungsformen erläutert.

In einer ersten Ausführungsform weist ein jeder Prüfkopf 38 eine Kamera für einen optische Test und einen Prüffinger für einen elektrischen Test auf. Je nach Bedarf wird die Kamera zur Durchführung des optischen Meßverfahrens oder der Prüffinger zur Durchführung des elektrischen Meßverfahrens verwendet. Mit einer solchen Vorrichtung kann das oben beschriebene erfindungsgemäße Verfahren durchgeführt werden.

In einer zweiten Ausführungsform ist jeweils ein Prüfkopf 38 einer Traverse 36 mit einer Kamera bestückt und der andere Prüfkopf 38 der Traverse 36 weist einen Prüffinger auf. Die Prüfköpfe 38 mit den Kameras dienen zur Durchführung des optischen Meßverfahrens und die Prüfköpfe 38 mit den Prüffingern dienen zur Durchführung des elektrischen Meßverfahrens.

In einer dritten Ausführungsform sind alle Prüfköpfe 38 mit Prüffingern bestückt und eine Kamera zur Durchführung des optischen Meßverfahrens ist oberhalb der Traversen 36 angeordnet. Die Kamera ist vorzugsweise auf einer zusätzlichen Schiene verschiebbar geführt, wobei die Schiene in Längsrichtung der Leiterplatte 2 angeordnet ist.

Diese integrierten Vorrichtungen erlauben es, daß die Leiterplatte 2 an einem einzigen Ort verbleiben kann, während das vollständige erfindungsgemäße Verfahren durchgeführt wird. Gegenüber herkömmlichen Fingertestern wird ein wesentlicher Vorteil erzielt, da mit der optischen Messung bereits die Lage der zu testenden Leiterplatte exakt erfaßt ist und ein zusätzliche Ausrichten (Allignement) der Leiterplatte nicht durchgeführt werden muß, das ansonsten notwendig wäre, um die Prüffinger gegenüber der Leiterplatte auszurichten.

Bei der erfindungsgemäßen Vorrichtung ist es grundsätzlich auch möglich anstatt der Prüfköpfe die zu prüfende Leiterplatte zu verfahren, wie es von optischen Testvorrichtungen bereits bekannt ist.

## Patentansprüche

1. Verfahren zum Prüfen von Leiterplatten,
wobei zur Ermittlung optischer Fehler eine zu prüfende Leiterplatte optisch abgetastet wird, und
Netze der zu prüfenden Leiterplatte, die in der Nähe der optischen Fehler angeordnet sind, elektrisch nachgemessen werden.

2. Verfahren nach Anspruch 1,
**dadurch gekennzeichnet,**
daß die optischen Fehler durch Vergleichen einer Ist-Abbildung mit einer Referenz-Abbildung erhalten werden, wobei Abweichungen zwischen der Ist-Abbildung und der Referenz-Abbildung als optische Fehler bewertet werden und mit ihren Ortskoordinaten in eine Fehlerdatei abgespeichert bzw. an eine Einrichtung zum elektrischen Prüfen der Leiterplatte übertragen werden.

3. Verfahren nach Anspruch 2,
**dadurch gekennzeichnet,**
daß nach Maßgabe der Ortskoordinaten der optischen Fehler Netze der zu prüfenden Leiterplatte im Bereich der optischen Fehler elektrisch nachgemessen werden.

4. Verfahren nach einem der Ansprüche 1 bis 3,
**dadurch gekennzeichnet,**
daß zumindest ein Netz der zu prüfenden Leiterplatte beim elektrischen Nachmessen auf eine Unterbrechung geprüft wird.

5. Verfahren nach Anspruch 4,
**dadurch gekennzeichnet,**
daß das elektrische Nachmessen auf eine Unterbrechung mittels einer Leitwertmessung erfolgt.

6. Verfahren nach einem der Ansprüche 1 bis 5,
**dadurch gekennzeichnet,**
daß zumindest zwei Netze der zu prüfenden Leiterplatte beim elektrischen Nachmessen auf einen Kurzschluß zwischen den beiden Netzen geprüft werden.

7. Verfahren nach Anspruch 6,
**dadurch gekennzeichnet,**
daß das elektrische Nachmessen auf einen Kurzschluß mittels einer Widerstandsmessung erfolgt.

8. Verfahren nach Anspruch 6,
**dadurch gekennzeichnet,**
daß das elektrische Nachmessen auf einen Kurzschluß mittels einer magnetischen Sonde erfolgt, mit welcher ein an die zu testenden Netze angelegter Strom verfolgt wird.

9. Verfahren nach einem der Ansprüche 1 bis 8,
**dadurch gekennzeichnet,**
daß zum optischen Abtasten eine digitale Kamera verwendet wird, mit welcher eine gemessene Abbildung der Leiterplatte erhalten wird, die durch eine Bilddaten-Datei dargestellt wird.

10. Verfahren nach Anspruch 9,
**dadurch gekennzeichnet,**
daß die Bilddaten-Datei digitalisiert wird.

11. Verfahren nach Anspruch 9 oder 10,
**dadurch gekennzeichnet,**
daß die Bilddaten-Datei mittels eines Erkennungsprogrammes gelesen wird, das einzelne Leiterbahnen, Kontaktstellen und dgl. erkennt und die mit ihren Koordinaten in einer Elementen-Datei abgespeichert werden.

12. Verfahren nach Anspruch 11,
**dadurch gekennzeichnet,**
daß die Elementen-Datei als Ist-Abbildung verwendet und mit der Referenz-Abbildung verglichen wird.

13. Vorrichtung zur Durchfuhrung eines Verfahrens zum Prüfen von Leiterplatten nach einem der Ansprüche 1 bis 9, mit zumindest einem optischen Sensor zum Abtasten der zu prüfenden Leiterplatte (2) und einem elektrischen Sensor zum elektrischen Nachmessen von durch den optischen Sensor ermittelten optischen Fehler der Leiterplatte (2).

14. Vorrichtung nach Anspruch 13,
**dadurch gekennzeichnet,**
daß der optische Sensor eine digitale Kamera (11) ist.

15. Vorrichtung nach Anspruch 13 oder 14,
**dadurch gekennzeichnet,**
daß der elektrische Sensor ein Prüffinger (19) eines Fingertesters ist.

16. Vorrichtung nach Anspruch 13 oder 14,
**dadurch gekennzeichnet,**
daß der elektrische Sensor eine Magnetfeldsonde ist.

17. Vorrichtung nach einem der Ansprüche 13 bis 16,
**gekennzeichnet durch**
ein Förderband (1) zum Befördern der zu testenden Leiterplatten (2) zwischen einer Vereinzelungseinrichtung (4) und Magazinen (22, 24), wobei in Förderrichtung (3) entlang dem Förderband (1) eine optische Prüfeinrichtung (10) und eine elektrische Prüfeinrichtung (15) angeordnet sind.

18. Vorrichtung nach Anspruch 17,
**dadurch gekennzeichnet,**
daß zwischen der optischen Prüfeinrichtung (10) und der elektrischen Prüfeinrichtung (15) ein weiteres Magazin (30) angeordnet ist.

19. Vorrichtung nach Anspruch 17 oder 18,
**dadurch gekennzeichnet,**
daß eine zentrale Steuereinrichtung zum Steuern aller Vorgange, wie dem Zuführen der Leiterplatten (2), dem Befördern auf dem Förderband (1), dem optischen und elektrischen Abtasten und dem Zuführen der getesteten Leiterplatten in die Magazine (22, 24, 30) vorgesehen ist.

20. Vorrichtung nach einem der Ansprüche 13 bis 17,
**dadurch gekennzeichnet,**
daß die Vorrichtung zwei zueinander parallel angeordnete Schienen (35) aufweist, zwischen welchen ein Aufnahmebereich für eine zu prüfende Leiterplatte (2) ausgebildet ist, wobei auf den Schienen zumindest zwei Traversen (36) lagern, die sich quer über den Aufnahmebereich für die zu prüfende Leiterplatte (2) erstrecken, die auf den Schienen (35) verfahrbar sind, wobei auf den Traversen (36) jeweils zumindest ein Prüfkopf (38) verfahrbar angeordnet ist.

21. Vorrichtung nach Anspruch 20,
**dadurch gekennzeichnet,**
daß ein jeder Prüfkopf (38) einen der optischen Sensoren und einen der elektrischen Sensoren aufweist.

22. Vorrichtung nach Anspruch 20,
**dadurch gekennzeichnet,**
daß an jeder Traverse (36) zumindest zwei Prüfköpfe (38) angeordnet sind, wobei jeweils ein Prüfkopf (38) einer Traverse mit einem der optischen Sensoren versehen ist und der andere Prüfkopf (38) mit einem der elektrischen Sensoren versehen ist.

23. Vorrichtung nach Anspruch 20,
**dadurch gekennzeichnet,**
daß alle Prüfköpfe (38) mit elektrischen Sensoren versehen sind und ein optischer Sensor unabhängig von den Traversen (36) angeordnet ist.
